# EUROPEAN PATENT SPECIFICATION

(11) **EP 2 523 215 B1**
(45) Date of publication and mention of the grant of the patent: **18.02.2015**
(21) Application number: 11166016.3
(22) Date of filing: 13.05.2011
(51) Int. Cl.: H01L 23/473

(54) **Liquid cooling element**
Flüssigkeitskühlelement
Élément de refroidissement liquide

(43) Date of publication of application: 14.11.2012
(73) Proprietor: ABB Oy, 00380 Helsinki (FI)
(72) Inventor: Seväkivi, Pertti, 01830, Lepsämä (FI); Kärppä, Jaani, 02600, Espoo (FI)
(74) Representative: Kolster Oy Ab

(56) References cited:
- EP-A1- 0 453 763
- EP-A2- 2 080 978
- WO-A2-2006/100690
- JP-A- 61 104 645
- JP-A- 2004 103 936
- US-A- 5 309 319
- US-A1- 2006 002 087
- US-B1- 6 351 384

## Description

### FIELD OF THE INVENTION

The present invention relates to cooling of power semiconductors and particularly to liquid cooling of power semiconductor modules.

### BACKGROUND INFORMATION

As present-day power semiconductors are not ideal, they produce heat as a side product. At the same time, in order for a semiconductor to function, its temperature has to be kept within a given range. Therefore, the semiconductor has typically to be cooled.

There are many approaches for cooling a semiconductor, typically comprising a cooling element which conducts the heat away from the semiconductors. The cooling element may, for instance, be a heat sink which is cooled by air flow. The flow of air may be gravitational or produced mechanically.

Air-cooled heat sinks are sufficient for applications for lower power. As the maximum power transferred rises, also the amount of dissipated heat rises. Air has limited thermal capacity, and therefore, an air cooling element required may become at some point so bulky and expensive that air cooling is impractical.

Some liquids, such as water, have much higher thermal capacity than air. They can transfer heat from the semiconductors more efficiently. However, liquid cooling typically requires a circulatory system, which is more complex than an open system like air cooling. Extra care may have to be taken in order to avoid leaks because the liquid may be electrically conductive and cause short circuits in the arrangement to be cooled.

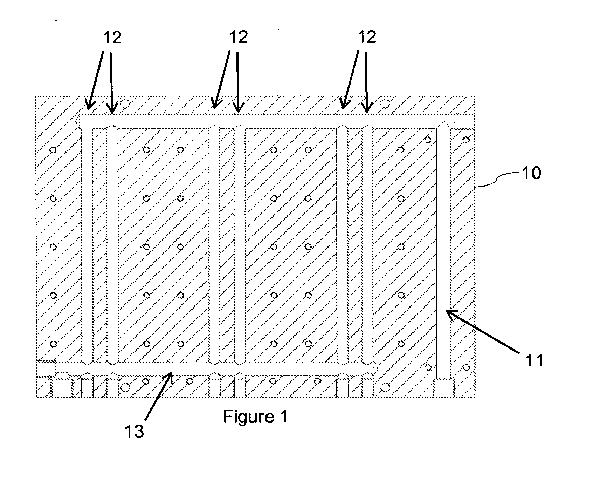

Figure 1 illustrates a liquid cooling arrangement for three power semiconductor modules arranged in parallel on a cooling plate 10. The cooling plate 10 is made of a thermally conducting material. The semiconductor modules may comprise a plurality of power semiconductor units. A semiconductor unit may, for instance, comprise a diode, a transistor, or both. Typically a power semiconductor unit comprises an IGBT in parallel with a diode, and a power semiconductor module comprises one or more of these power semiconductor units.

The cooling plate 10 comprises channels in which the cooling liquid may run. A main supply channel 11 branches into a plurality of cooling channels 12. In Figure 1, two cooling channels 12 run under each module, cooling the power semiconductor units. The cooling channels 12 then join to a main discharge channel 13. The channels 11, 12, and 13 may be produced into the cooling plate 10 for instance by drilling and plugging some of the drill hole entrances.

By using the liquid cooling, the semiconductor modules can be cooled more efficiently than by using air cooling. However, the heat distribution may be uneven. This may be problematic because the hottest point of a semiconductor module determines the maximum load on the module. Uneven heat distribution may also cause mechanical strain to the power semiconductor modules.

European patent application EP 0 453 763 A1 disclose a flexible cooling hat which is attached on top of components on a PCB. The cooling hat is a composite structure comprising a thermally conducting coldsheet and a plurality of rubber manifold layers forming conduits for a coolant. The conduits supply the coolant to cool the coldsheet.

Japanese patent application JP 2004 103936 A discloses a cooling element for cooling semiconductor chips of a power semiconductor module. A metal wire attached to the bottom plate of the module conducts heat to a cooling fluid which flows in channels formed by attaching a cover to the bottom plate.

### SUMMARY

An object of the present invention is to provide a method and an apparatus for implementing the method so as to alleviate the above disadvantage. The objects of the invention are achieved by a method and an apparatus which are characterized by what is stated in the independent claims. Preferred embodiments of the invention are disclosed in the dependent claims.

A cooling element according to the present invention comprises a cooling plate which comprises channels for carrying a flow of a cooling liquid. A main supply channel for the cooling liquid breaks up in supply channel branches. These branches further divide into cooling channels. The cooling plate may have a separate cooling channel or channels under each power semiconductor unit. The cooling plate may have openings between the power semiconductor modules so that they will not heat each other.

The cooling channels under the power semiconductor units are parallel to each other, and therefore, cooling of one power semiconductor unit does not affect cooling of another power semiconductor unit. The cooling channels recombine into discharge channel branches which, in turn, recombine into a main discharge channel.

To enhance exchange of heat, the channels and channel branches may be provided with fins. The main supply channel may be formed to be converging in the direction of the liquid flow, and the main discharge channel may be formed to be diverging in the direction of the liquid flow. In this manner, equal flow in the supply channel branches and the discharge channels branches may be achieved. The supply channel branches and the discharge channel branches may be formed converging and diverging in order to achieve even flow in the cooling channels.

### BRIEF DESCRIPTION OF THE DRAWINGS

In the following the invention will be described in greater detail by means of preferred embodiments with reference to the attached drawings, in which
Figure 1 illustrates a liquid cooling arrangement;
Figures 2a, 2b, and 2c illustrate an exemplary embodiment of the present disclosure; and
Figures 3a and 3b illustrate an isometric view of an exemplary cooling plate according to the present disclosure.

### DETAILED DESCRIPTION

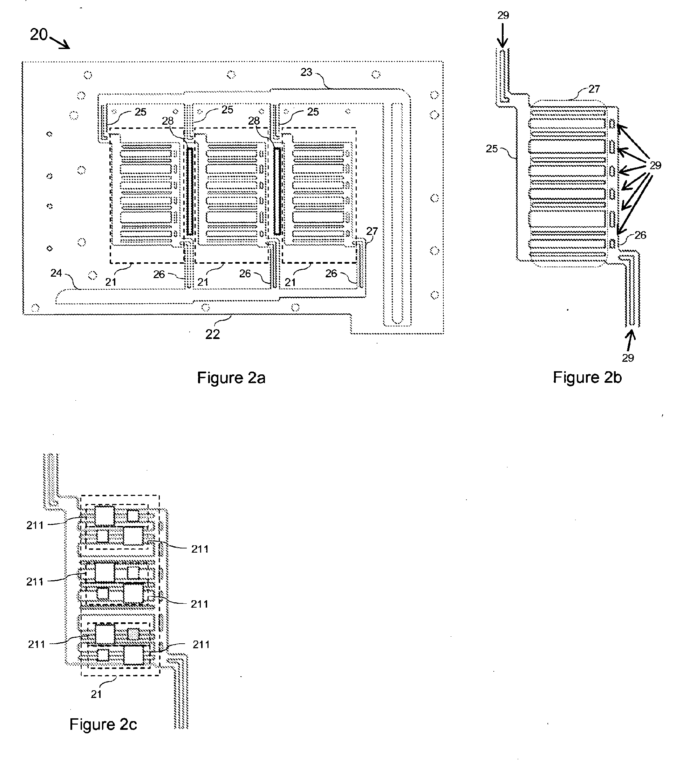

Figures 2a, 2b, and 2c illustrate an exemplary embodiment according to the present disclosure. A cooling element 20 for cooling a plurality of power semiconductor modules 21 comprising power semiconductor units comprises a plate 22 made of thermally conductive material. In Figure 2a, three modules 21 are used. Figure 2b shows details for cooling of one of the modules 21 of Figure 2a. Figure 2c illustrates an exemplary positioning of power semiconductor units 211 inside a power semiconductor module 21.

A power semiconductor unit may, for instance, comprise a diode, a transistor, or both. Typically, the power semiconductor units comprise an IGBT and a diode. In Figure 2c, each power semiconductor unit 211 comprises a diode (smaller square) and an IGBT (larger square). Other semiconductors and/or configurations of power semiconductor units and modules may also be used.

The cooling plate 22 is adapted to be thermally connected to the power semiconductor modules 21. In Figure 2a, the power semiconductor modules 21 are arranged next to each other on the cooling plate 22. The modules 21 may be attached to the cooling plate 22, for instance, by screws to ensure adequate thermal connection.

The cooling plate 22 comprises channels for carrying a flow of a cooling liquid. The channels form a circulatory system. The channels comprise a main supply channel 23 into which the cooling liquid is fed, and a main discharge channel 24 from which the cooling liquid heated by the power semiconductor units is discarded. The cooling plate 22 with channels may, for instance, be machined from a block and sealed with a close-fitting lid.

The main supply channel 23 divides into a plurality of supply channel branches 25 branching from the main input channel 23. The main discharge channel 24 is divided into branches in a similar manner. In Figure 2a, a plurality of discharge channel branches 26 merge to the main discharge channel 24.

A plurality of power semiconductor unit cooling channels 27 connects the supply channel branches 25 and the discharge channel branches 26, as illustrated in Figure 2b. Each power semiconductor unit cooling channel 27 may be arranged to cool one power semiconductor unit.

However, a power semiconductor unit may have more than one cooling channel 27 cooling the power semiconductor unit. The number of cooling channels 27 per semiconductor unit depends on the configuration of the power semiconductor module 21. Figure 2c shows two cooling channels per power semiconductor unit 211.

The cooling channels 27 are parallel to each other. In contrast to the cooling element of Figure 1, cooling of one power semiconductor unit does not affect cooling of another power semiconductor unit. Each power semiconductor unit in a power semiconductor module 21 receives equally cool cooling liquid, and a temperature difference between the power semiconductor units can thus be minimized. As a result, the power semiconductor module 21 can withstand higher currents. As the heat produced by the module 21 is distributed more evenly, the power semiconductor module 21 may also experience less mechanical strain.

In Figure 1, the main supply channel 11 and the main discharge channel 13 both have cross sections which are uniform in respect of their lengths. This may cause the cooling channels 12 to have uneven flows. The amount of flowing liquid is reduced as cooling channels branch off the main supply channel 11, thus allowing higher speed of the flow in the following cooling channels. At the same time, flows in cooling channels farther away from a discharge channel exit point are slowed down by cooling channels nearer the exit point.

In the cooling element according to the present disclosure, the main supply channel may be formed to converge in the direction of the flow of the liquid, and the main discharge channel may be formed to diverge in the direction of the flow of the liquid, as in Figure 2a. More equal flow (and pressure) in the supply channel branches and the discharge channel branches can thus be achieved.

The supply channel branches may also be arranged to converge in the direction of the flow of the liquid and the discharge channel branches to diverge in the direction of the flow of the liquid.

To enhance exchange of heat, the channels may be provided with fins 29, as in Figure 2b, thus producing turbulence in the flow of the liquid and increasing the surface area between the cooling liquid and walls of the channels.

In general, when a cooling plate is made of a thermally conducting material, heat produced by a power semiconductor module may cause a rise in the temperature in another power semiconductor module. In order to avoid exchange of heat between the power semiconductor modules, the plate may comprise openings 28 for thermally separating the power semiconductor modules from each other, as in Figure 2a.

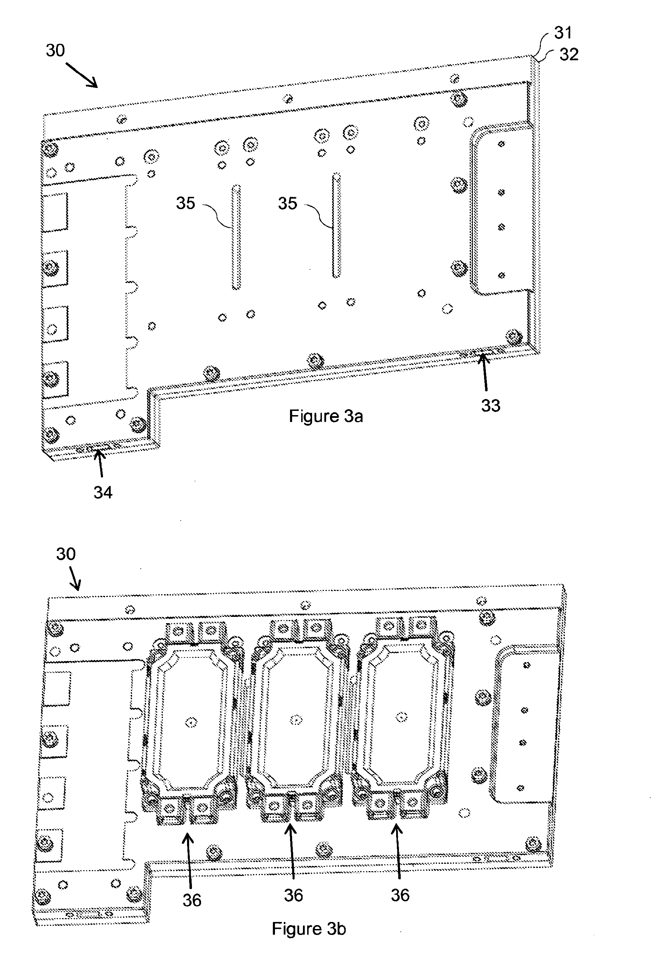

Figure 3a illustrates an isometric view of an exemplary cooling plate 30 with thermal separation of power semiconductor units. The cooling plate 30 is assembled from a top side metal plate 31 and a bottom side metal plate 32 which are fastened together by screws. The metal plates 31 and 32 are made of aluminium. However, other thermally conductive materials, for example copper, may also be used.

The top side metal plate 31 comprises channels for carrying a flow of a cooling liquid. The channels are sealed with the bottom metal plate 32. An entry opening 33 for a main supply channel can be seen on bottom left corner of Figure 3a. An exit opening 34 for a main discharge channel can be found in the bottom right corner of Figure 3a.

The top side metal plate 31 is configured to accommodate three power semiconductor modules. Two openings 35 in the top side metal plate 31 thermally separate three power semiconductor modules. In Figure 3a the openings 35 protrude into some depth of the plate. However, in some embodiments, the openings may go all the way through the cooling plate.

Figure 3b illustrates an isometric view of the same cooling plate 30 with three power semiconductor modules 36 mounted on it. Without the openings 35, the power semiconductor module in the middle in Figure 3b would operate at a higher temperature than the power semiconductor modules on the sides because the modules on the sides would heat up the module in the middle.

In some embodiments, the supply channel branches may originate from the main supply channel at the same point, and/or the discharge channel branches may merge into the main discharge channel at the same point. Alternatively, the main supply channel can be provided with dividing walls separating liquid flows of the supply channel branches, and the main discharge channel can be provided with dividing walls separating liquid flows of the discharge channel branches. In both cases, the flows of the branches would be separate from each other. Thus, the flow speed would be approximately the same for each branch.

It will be obvious to a person skilled in the art that the inventive concept can be implemented in various ways. The invention and its embodiments are not limited to the examples described above but may vary within the scope of the claims.

## Claims

1. A cooling element for cooling a plurality of power semiconductor modules (21; 36) comprising power semiconductor units (211), wherein the cooling element comprises a plate (22; 30) made of thermally conductive material, wherein the plate (22; 30) is adapted to be thermally connected to the power semiconductor modules (21; 36), the plate (22; 30) comprises channels for carrying a flow of a cooling liquid, wherein the channels comprise
a main supply channel (23) converging in the direction of the flow of the liquid,
a main discharge channel (24) diverging in the direction of the flow of the liquid,
a plurality of supply channel branches (25) branching from the main input channel (23),
a plurality of discharge channel branches (26) merging to the main discharge channel (24), and
a plurality of power semiconductor unit cooling channels (27) connecting the supply channel branches (25) and the discharge channel branches (26);
each power semiconductor unit cooling channel (27) is arranged to cool one power semiconductor unit (211); and **characterized in that**
the plate (22; 30) comprises openings (28; 35) for thermally separating the power semiconductor modules (21; 36) from each other.

2. A cooling element according to claim 1, wherein the channels are provided with fins (29) for producing turbulence in the flow of the liquid.

3. A cooling element according to claim 1 or 2, wherein the main supply channel (23) is provided with dividing walls separating liquid flows of the supply channel branches (25).

4. A cooling element according to any of claims 1 to 3, wherein the main discharge channel (24) is provided with dividing walls separating liquid flows of the discharge channel branches (26).

5. A cooling element according to any of claims 1 to 4, wherein the supply channel branches (25) converge in the direction of the flow of the liquid and the discharge channel branches (26) diverge in the direction of the flow of the liquid.

## Patentansprüche

1. Kühlelement zur Kühlung mehrerer Leistungshalbleitermodule (21; 36), die Leistungshalbleitereinheiten (211) aufweisen, wobei das Kühlelement eine aus einem wärmeleitenden Material hergestellte Platte (22; 30) aufweist, wobei die Platte (22; 30) angepasst ist, thermisch mit den Leistungshalbleitermodulen (21; 36) verbunden zu sein, welche Platte (22; 30) Kanäle zur Führung eines Flusses einer Kühlflüssigkeit aufweist, wobei die Kanäle aufweisen:
einen Hauptspeisekanal (23), der sich in Richtung des Flusses der Flüssigkeit verengt,
einen Hauptauslasskanal (24), der sich in Richtung des Flusses der Flüssigkeit erweitert,
mehrere Speisekanalabzweige (25), die vom Haupteinlasskanal (23) abzweigen,
mehrere Auslasskanalabzweige (26), die in den Hauptauslasskanal (24) einmünden, und
mehrere Kühlkanale (27) für Leistungshalbleitereinheiten, die die Speisekanalabzweige (25) und die Auslasskanalabzweige (26) verbinden;
jeder Kühlkanal (27) für Leistungshalbleitereinheiten angeordnet ist, eine Leistungshalbleitereinheit (211) zu kühlen; und **dadurch gekennzeichnet,dass**
die Platte (22; 30) Öffnungen (28; 35) zur thermischen Trennung der Leistungshalbleitermodule (21; 36) voneinander aufweisen.

2. Kühlelement nach Patentanspruch 1, worin die Kanäle mit Rippen (29) versehen sind, um Turbulenz im Fluss der Flüssigkeit zu erzeugen.

3. Kühlelement nach Patentanspruch 1 oder 2, worin der Hauptspeisekanal (23) mit Trennwänden versehen ist, die Flüssigkeitsflüsse der Speisekanalabzweige (25) trennt.

4. Kühlelement nach einem der Patentansprüche 1 bis 3, worin der Hauptspeisekanal (24) mit Trennwänden versehen ist, die Flüssigkeitsflüsse der Auslasskanalabzweige (26) trennt.

5. Kühlelement nach einem der Patentansprüche 1 bis 4, worin sich die Speisekanalabzweige (25) in Richtung des Flusses der Flüssigkeit verengen und die Auslasskanalabzweige (26) sich in Richtung des Flusses der Flüssigkeit erweitern.

## Revendications

1. Elément de refroidissement pour refroidir une pluralité de modules de semiconducteur de puissance (21 ; 36) comprenant des unités de semiconducteur de puissance (211), dans lequel l'élément de refroidissement comprend une plaque (22 ; 30) en matériau thermiquement conducteur, dans lequel la plaque (22 ; 30) est adaptée pour être reliée thermiquement à des modules de semiconducteur de puissance (21 ; 36), la plaque (22 ; 30) comprend des canaux pour transporter un flux d'un liquide de refroidissement, dans lequel les canaux comprennent
un canal d'alimentation principal (23) convergent dans la direction du flux du liquide,
un canal d'évacuation principal (24) divergent dans la direction du flux du liquide,
une pluralité de branches de canal d'alimentation (25) se ramifiant du canal d'entrée principale (23),
une pluralité de branches de canal d'évacuation (26) se rejoignant au canal d'évacuation principal (24), et
une pluralité de canaux de refroidissement d'unité de semiconducteur de puissance (27) connectant les branches de canal d'alimentation (25) et les branches de canal d'évacuation (26) ;
chaque canal de refroidissement d'unité de semiconducteur de puissance (27) est configuré pour refroidir une unité de semiconducteur de puissance (211); et
**caractérisé en ce que** la plaque (22 ; 30) comprend des ouvertures (28 ; 35) pour la séparation thermique des modules de semiconducteur de puissance (21 ; 36) les uns des autres.

2. Elément de refroidissement selon la revendication 1, dans lequel les canaux sont fournis avec des ailettes (29) pour produire une turbulence dans le flux du liquide.

3. Elément de refroidissement selon la revendication 1 ou la revendication 2, dans lequel le canal d'alimentation principal (23) est fourni avec des parois de séparation séparant des flux de liquide des branches de canal d'alimentation (25).

4. Elément de refroidissement selon l'une quelconque des revendications 1 à 3, dans lequel le canal d'évacuation principal (24) est fourni de parois de séparation séparant des flux de liquide des branches de canal d'évacuation (26).

5. Elément de refroidissement selon l'une quelconque des revendications 1 à 4, dans lequel les branches de canal d'alimentation (25) convergent dans la direction du flux du liquide et les branches de canal d'évacuation (26) divergent dans la direction du flux du liquide.
